# EUROPÄISCHE PATENTSCHRIFT

(11) **EP 0 520 295 B1**
(45) Veröffentlichungstag und Bekanntmachung des Hinweises auf die Patenterteilung: **14.09.1994**
(21) Anmeldenummer: 92110138.2
(22) Anmeldetag: 16.06.1992
(51) Int. Cl.: H05K 13/00

(54) **Verfahren und Anordnung zur Ausformung der Aussenanschlüsse von oberflächenmontierbaren Bausteinen**
Method and device for forming external connections in surface mounted components
Procédé et dispositif pour former des conduites extérieures avec des éléments constitutifs montables à la surface

(30) Priorität: 26.06.1991 DE 4121108
(43) Veröffentlichungstag der Anmeldung: 30.12.1992
(73) Patentinhaber: Siemens Nixdorf Informationssysteme Aktiengesellschaft, 33102 Paderborn (DE)
(72) Erfinder: Schweizer, Matthias, W-8894 Igenhausen (DE)
(74) Vertreter: Fuchs, Franz-Josef, Dr.-Ing.

(56) Entgegenhaltungen:
- EP-A- 0 141 279
- EP-A- 0 289 166
- EP-A- 0 405 977
- EP-A- 0 438 853
- DE-U- 8 531 940

## Beschreibung

Die Erfindung betrifft ein Verfahren zum Ausformen der Außenanschlüsse von oberflächenmontierbaren, auf einem Filmträger aufgebrachten, integrierten Bausteinen (Mikropacks); siehe z.B. DE-U-8 531 940.

Nach dem Ausschneiden von oberflächenmontierbaren, auf einem Filmträger aufgebrachten integrierten Bausteinen, wie z.B. Mikropacks, nehmen die Außenanschlüsse (Outerleads), hervorgerufen durch innere Spannungen, im allgemeinen eine maßungenaue Stellung ein. Beim anschließenden Biegen der Outerleads werden diese Lagefehler noch verstärkt, mit der Folge, daß sich der Baustein nicht mehr zu den Lötflecken (Pads) der jeweiligen Leiterplatte ausrichten läßt.

Aufgabe der vorliegenden Erfindung ist es daher, ein Verfahren und eine Anordnung zum Ausformen der Außenanschlüsse von oberflächenmontierbaren, auf einem Filmträger aufgebrachten integrierten Bausteinen (Mikropacks) anzugeben, durch das die Lagerichtigkeit der einzelnen Außenanschlüsse der Bausteine zueinander und zu den zugehörigen Lötpads gewährleistet ist.

Gemäß der Erfindung nach Anspruch 1 wird dabei so verfahren, daß im Filmträger vier im Viereck angeordnete, zueinander senkrecht verlaufende Schlitze eingebracht werden, die so angeordnet sind, daß an ihren, dem Bausteinkörper zugewandten Seiten Haltestege aus Filmträgermaterial erhalten bleiben, so daß jeweils alle Außenanschlüsse einer Seite miteinander verbunden bleiben, daß anschließend die Haltestege an den vier Ecken des Bausteins aufgetrennt und die Aussenanschlüsse in die vorgegebene Form gebogen werden und daß danach die Außenanschlüsse auf die endgültige Länge beschnitten werden.

Die Anordnung nach Anspruch 2, zur Durchführung des Verfahrens sieht einen Schlitzautomaten und einem Schneidbiegeautomaten vor, der ein vertikal bewegbares Schneidbiegewerkzeug aufweist, das aus vier miteinander starr verbundenen, im Viereck angeordneten Biegestempeln, die jeweils an ihren beiden Schmalseiten in horizontaler Verlängerung in Schneidstempel zum Auftrennen der Haltestege auslaufen und die in der Vertikalen, über die untere Biegestempelkante hinausragen und aus vier Beschneidungsstempeln besteht, die unmittelbar hinter den Biegestempeln angeordnet sind, und relativ zu diesen vertikal bewegbar sind, wobei das Schneidbiegewerkzeug zu seinem Antrieb mit einem Pneumatikzylinder gekoppelt ist, wobei ferner unterhalb des Schneidbiegewerkzeuges ein als rechteckige Hohlsäule ausgebildetes, an seinen Oberkanten entsprechend der gewünschten Ausformung der Außenanschlüsse der Bausteine faconiertes und auf die Form der unteren Biegestempelkante abgestimmtes Biegeunterteil angeordnet ist, in dessen Hohlraum ein der äußeren Formgebung des jeweiligen Bausteingehäuses abgestimmtes Stützelement vertikal verschiebbar angeordnet ist, wobei an den vier Ecken des Biegeunterteils unterhalb eines vorgegebenen Abstandes von der Oberkante des Biegeunterteils Aufschlagstükke zur Begrenzung des Hubes des Schneidbiegewerkzeuges vorgesehen sind, und daß in dem durch die Biegestempel gebildeten Innenraum ein sich auf dem Biegeunterteil abstützender fest montierter Bausteinniederhalter angeordnet ist.

Durch dieses Verfahren und die dazugehörige Anordnung wird erreicht, daß zunächst ein Haltesteg aus Filmträgermaterial, wie z.B. Kapton® oder Upilex®, über die Außenanschlüsse der vier Seiten erhalten bleibt, so daß durch das anschließende Biegen keine Verdrehung oder seitliches Ausweichen der Außenanschlüsse der Bausteine durch auftretende Torsions- und Längsspannungen erfolgen kann. Damit kann der so vorbereitete Baustein unmittelbar nach dem Biegen ohne zusätzliche Nacharbeit unmittelbar auf die zugehörige Leiterplatte aufgelötet werden, da die Outerleads exakt im Teilungsabstand gehalten werden. Innere Spannungen der einzelnen Outerleads werden beim Biegevorgang abgebaut.

Anhand der Ausführungsbeispiele nach den FIG 1 bis 3 wird die Erfindung näher erläutert. Es zeigen
FIG 1a bis d den in vier Schritten erfolgenden Verfahrensablauf in schematischer Darstellung,
FIG 2a und b einen Querschnitt und eine Draufsicht auf das Schneidbiegewerkzeug vor dem Abschneiden der überstehenden Teile der Outerleads und
FIG 3a und b den Querschnitt und die Draufsicht auf das Biegeunterteil.

Mit einem vorgeschalteten, in FIG 1a schematisch dargestellten Schlitzautomaten 1, werden in den Filmträger, der den Baustein und die Außenanschlüsse mitsamt den Prüfleitungen und den dazugehörigen Prüfpads trägt, und der in einem Trägerrähmchen eingesetzt ist und aus Kapton oder Upilex besteht, vier Schlitze 21 eingebracht, die so angeordnet sind, daß nach innen ein ca. 1,0 mm breiter Haltesteg 6 erhalten bleibt. Mit diesem Haltesteg sind die Outerleads 11 verbunden, so daß der gesamte Biegeprozeß im Verbund durchgeführt werden kann.

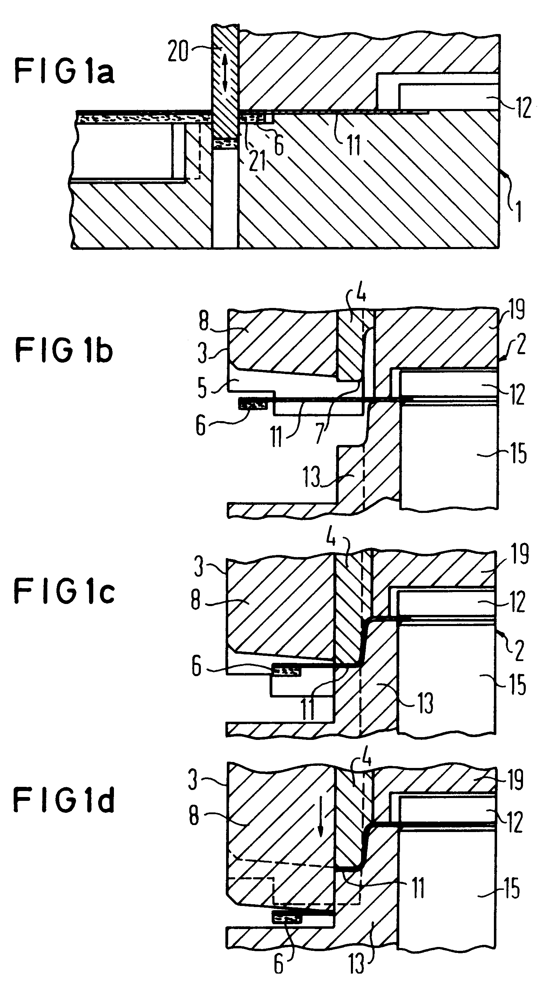

Nach dem Schlitzen wird der Baustein in den Schneidbiegeautomaten 2 eingeschoben, das Stützelement 15 im vorliegenden Fall in Vierkantform ausgebildet, führt von seiner Ausgangsposition eine Vertikalbewegung aus und hält den Baustein 12 im Niederhalter 19 fest (FIG 1b). Ein anschließendes Auftrennen der Haltestege 6 an den Stirnseiten erfolgt durch den Schneidbiegestempel 5, der später noch näher beschrieben wird. Im Folgeschritt werden vom Niederhalter 19 die Außenanschlüsse 11 auf das Biegeunterteil 13 gedrückt und festgehalten. Eine zugentlastende Wirkung auf die Innerleadbonding ist dadurch für den Biegevorgang gegeben. Die Bewegung des Biegestempels 4 zur Ausführung der Z-förmigen Biegung der Außenanschlüsse 11 erfolgt durch einen in der Figur nicht dargestellten Pneumatikzylinder. Die Endlage des Biegevorgangs wird durch vier Aufschlagstücke 17 begrenzt, so daß ein konstanter Biegespalt von ca. 0,4 mm gewährleistet ist (FIG 1c). Plastische Verformungen bzw. Druckstellen an den Außenanschlüssen 11 sind dadurch ausgeschlossen.

Mittels dem Beschneidestempel 8 (FIG 1d) werden vor dem Positionieren des Bausteins auf der Leiterplatte die überstehenden Teile 22 der Outerleads 11 mitsamt dem Haltesteg 6 abgetrennt und in einem Auffangbehälter entsorgt.

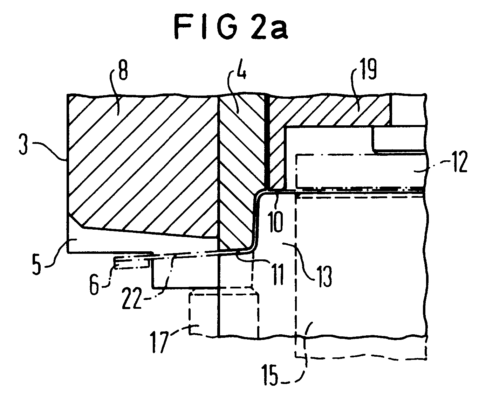

FIG 2a zeigt zunächst einen Querschnitt durch den Schneidbiegeautomaten 2. Das vertikal bewegbare Stützelement 15 ist in dem Hohlraum des rechteckig ausgebildeten Biegeunterteils 13 vertikal bewegbar angeordnet und klemmt den Bausteinkörper des Bausteins 12 an der Unterseite des Niederhalters 19 fest, der seinerseits auf den oberen Kanten 10 des Biegeunterteils 13 aufliegt.

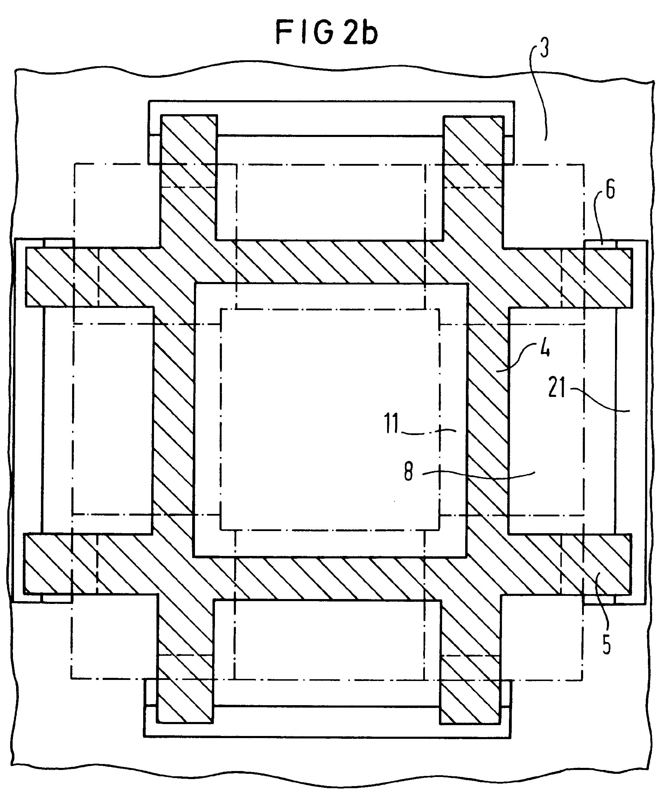

Das Schneidbiegewerkzeug weist vier im Rechteck zueinander angeordnete Biegestempel 4 auf (FIG 2b), die jeweils an ihren beiden Schmalseiten in horizontaler Verlängerung in Schnittstempel 5 zum Auftrennen der Haltestege 6 auslaufen, und die in der Vertikalen über die untere Biegestempelkante 7 herausragen. Vom Bausteinkörper aus gesehen hinter den Biegestempeln 4 sind relativ zu diesen vertikal bewegbar vier Beschneidungsstempel 8 angeordnet.

Das Biegeunterteil 13 ist an seinen vier Seiten entsprechend der gewünschten Form der Ausbiegung faconiert, so daß durch das Niedergleiten des Biegestempels 4 die gewünschte Form im vorliegenden Fall eine Z-ähnliche Form erreicht wird. Das Abschneiden der überstehenden Teile 22 der Outerleads 11 mitsamt dem Haltesteg 6, erfolgt über die Schneidstempel 8, die erst nach dem Biegevorgang in Bewegung gesetzt werden. Die Endlage des Schneidbiegewerkzeuges 3 wird durch die vier Aufschlagstücke 17, die jeweils unterhalb der vier Eckpunkte der Biegestempel 4 in einem vorgegebenen Abstand angeordnet sind, und auf die der vordere Teil der Unterkante des Schneidstempels 5 aufsitzt, in vertikaler Richtung begrenzt.

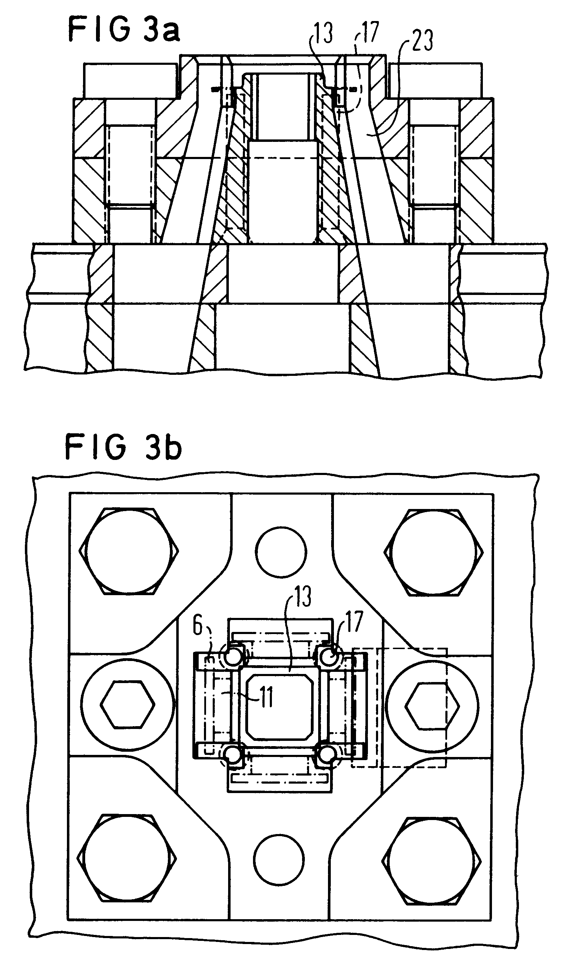

In FIG 3a und b ist das Biegeunterteil 13 näher dargestellt. Es zeigt in FIG 3a das Biegeunterteil 13 mit den dazugehörigen Aufschlagstücken 17 sowie den seitlich neben dem Biegeunterteil 13 verschlaufenden Abfallkanälen 23, in die die überstehenden Stücke der Outerleads 11 nach dem Schneidvorgang fallen und in einem darunter befindlichen Behälter aufgefangen werden. In der Draufsicht (FIG 3b) ist das Zusammenwirken des Schneidbiegewerkzeuges 3 mit dem Biegeunterteil zu erkennen.

## Patentansprüche

1. Verfahren zum Ausformen der Außenanschlüsse von oberflächenmontierbaren, auf einem Filmträger aufgebrachten integrierten Bausteinen, z.B. Mikropacks, wobei im Filmträger vier im Viereck angeordnete, zueinander senkrecht verlaufende Schlitze (29) eingebracht werden, die so angeordnet sind, daß an ihren, dem Bausteinkörper zugewandten Seiten Haltestege (6) aus Filmträgermaterial erhalten bleiben, so daß jeweils alle Außenanschlüsse (11) einer Seite miteinander verbunden bleiben, anschließend die Haltestege (6) an den vier Ecken des Bausteins (12) aufgetrennt und die Außenanschlüsse (11) in die vorgegebene Form gebogen werden und danach die Außenanschlüsse (11) auf die endgültige Länge beschnitten werden.

2. Anordnung zur Durchführung des Verfahrens nach Anspruch 1, **gekennzeichnet durch** einen Schlitzautomaten (1) und einen Schneidbiegeautomaten (2), der ein vertikal bewegbares Schneidbiegewerkzeug (3) aufweist, das aus vier miteinander starr verbundenen, im Viereck angeordneten Biegestempeln (4), die jeweils an ihren beiden Schmalseiten in horizontaler Verlängerung in Schneidstempel (5) zum Auftrennen der Haltestege (6) auslaufen und die in der Vertikalen, über die untere Biegestempelkante (7) hinausragen und aus vier Beschneidungsstempeln (8) besteht, die unmittelbar hinter den Biegestempeln (4) angeordnet sind, und relativ zu diesen vertikal bewegbar sind, und daß das Schneidbiegewerkzeug (3) zu seinem Antrieb mit einem Pneumatikzylinder gekoppelt ist, daß unterhalb des Schneidbiegewerkzeuges (3) ein als rechtekkige Hohlsäule ausgebildetes, an seinen Oberkanten (10) entsprechend der gewünschten Ausformung der Außenanschlüsse (11) der Bausteine (12) faconiertes und auf die Form der unteren Biegestempelkante (7) abgestimmtes Biegeunterteil (13) angeordnet ist, in dessen Hohlraum (14) ein der äußeren Formgebung des jeweiligen Bausteingehäuses abgestimmtes Stützelement (15) vertikal verschiebbar angeordnet ist, daß an den vier Ekken des Biegeunterteils (13) unterhalb eines vorgegebenen Abstandes von der Oberkante (10) des Biegeunterteils (13) Aufschlagstücke (17) zur Begrenzung des Hubes des Schneidbiegewerkzeuges (3) vorgesehen sind, und daß in dem durch die Biegestempel (4) gebildeten Innenraum ein sich auf dem Biegeunterteil abstützender fest montierter Bausteinniederhalter (19) angeordnet ist.

## Claims

1. Method for forming external connections of surface mounted integrated devices, for example micro-packs, which are fitted on a film substrate, there being incorporated in the film substrate four slots (21) which are arranged in a quadrilateral shape at right angles to one another and are arranged such that retaining webs (6) composed of a film substrate material are maintained on their sides facing the device body so that all the external connections (11) on one side in each case remain connected to one another, the retaining webs (6) on the four corners of the device (12) are subsequently cut off and the external connections (11) are bent into the predetermined shape, and the external connections (11) are thereafter cut to the final length.

2. Arrangement for carrying out the method according to Claim 1, characterized by an automatic slotting machine (1) and an automatic cutting and bending machine (2) which has a cutting and bending tool (3) which can move vertically and comprises four bending stamps (4) which are rigidly connected to one another, are arranged in a quadrilateral shape, in each case end on their two narrow sides in a horizontal extension in the cutting stamp (5) for cutting off the retaining webs (6) and project vertically beyond the lower bending stamp edge (7), and comprises four cutting stamps (8) which are arranged immediately behind the bending stamps (4) and are movable vertically relative thereto, and in that the cutting and bending tool (3) is coupled to its drive by means of a pneumatic cylinder, in that a bending lower part (13) is arranged underneath the cutting and bending tool (3), which bending lower part (13) is constructed as a rectangular hollow column, is shaped on its upper edges (10) in accordance with the desired form of the external connections (11) of the devices (12) and is matched to the shape of the lower bending stamp edge (7) and in whose cavity (14) a supporting element (15) is arranged such that it can be displaced vertically, which supporting element (15) is matched to the external shape of the respective device housing, in that striking elements (17) for limiting the stroke of the cutting and bending tool (3) are provided a predetermined distance below the upper edge (10) of the bending lower part (13) on the four corners of the bending lower part (13), and in that a device hold-down member (19), which is firmly mounted and is supported on the bending lower part, is arranged in the internal space formed by the bending stamp (4).

## Revendications

1. Procédé pour former des bornes extérieures de modules intégrés pouvant être montés en surface, qui sont disposés sur un support de pellicule, par exemple des micropacks, dans lequel dans le support de pellicule on aménage quatre fentes (21) disposées en carré et perpendiculaires entre elles et qui sont disposées de telle sorte que des barrettes de retenue (6) en le matériau du support de pellicule subsistent sur leurs côtés tournés vers le corps du module, de sorte que toutes les bornes extérieures (11) d'un côté soient reliées entre elles, ensuite on sectionne les barrettes de retenue (6) aux quatre sommets du module (12) et on coude les bornes extérieures (11) à la forme prescrite et ensuite on découpe les bornes extérieures (11) à la longueur finale.

2. Dispositif pour la mise en oeuvre du procédé suivant la revendication 1, caractérisé par un automate d'entaillage (1) et un automate de découpage et coudage (2), qui possède un outil de découpage et coudage (3) déplaçable verticalement, qui est constitué de quatre poinçons de pliage (4), qui sont reliés rigidement entre eux, qui sont disposés en carré, qui se prolongent, sur leurs deux petits côtés, par un prolongement horizontal dans le poinçon de découpage (5) servant à sectionner les barrettes de retenue (6) et qui font saillie verticalement au delà de leur bord inférieur (7), et de quatre poinçons de découpage (8), qui sont disposés juste derrière les poinçons de coudage (4) et qui sont déplaçables verticalement par rapport à ces derniers, et que l'outil de découpage et coudage (3) est accouplé, pour son entraînement, à un vérin pneumatique, qu'au-dessous de l'outil de découpage et de coudage (3) est disposée une partie inférieure de coudage (13), qui est réalisée sous la forme d'une colonne évidée rectangulaire, est façonnée sur ses bords supérieurs (10) de manière à correspondre à la forme désirée des bornes extérieures (11) des modules (12) et est réglée sur la forme du bord inférieur (7) du poinçon de coudage, et dans la cavité (14) de laquelle est disposée, de manière à coulisser verticalement, un élément d'appui (15), qui est adapté à la configuration extérieure du boîtier respectif du module, que des éléments de butée (17) servant à limiter la course de l'outil de découpage et de coudage (3) sont prévus aux quatre sommets de la partie inférieure de coudage (13), à une distance prescrite au-dessous du bord supérieur (10) de la partie inférieure de coudage (13), et qu'un dispositif (19) de maintient des modules, qui est monté fixe et qui prend appui sur la partie inférieure de coudage, est disposé dans l'espace intérieur formé par les poinçons de coudage (4).
